# EUROPÄISCHE PATENTSCHRIFT

(11) **EP 2 215 666 B1**
(45) Veröffentlichungstag und Bekanntmachung des Hinweises auf die Patenterteilung: **29.08.2018**
(21) Anmeldenummer: 08855730.1
(22) Anmeldetag: 14.11.2008
(51) Int. Cl.: H01L 33/58, H01L 33/52

(54) **VERFAHREN ZUR HERSTELLUNG EINES OPTOELEKTRONISCHEN BAUELEMENTS**
METHOD FOR PRODUCING AN OPTOELECTRONIC COMPONENT
PROCÉDÉ DE FABRICATION D'UN COMPOSANT OPTOÉLECTRONIQUE

(30) Priorität: 29.11.2007 DE 102007057470; 13.03.2008 DE 102008014122
(43) Veröffentlichungstag der Anmeldung: 11.08.2010
(73) Patentinhaber: OSRAM Opto Semiconductors GmbH, 93055 Regensburg (DE)
(72) Erfinder: BLÜMEL, Simon, 84069 Schierling (DE); SCHNEIDER-PUNGS, Folke, 85283 Wolnzach (DE)
(74) Vertreter: Epping - Hermann - Fischer
(86) Internationale Anmeldenummer: PCT/DE2008/001888
(87) Internationale Veröffentlichungsnummer: WO 2009/067984

(56) Entgegenhaltungen:
- EP-A- 0 854 523
- EP-A- 1 341 278
- JP-A- 2001 203 395
- US-A1- 2006 263 918
- US-A1- 2007 170 454
- US-B1- 6 730 933

## Beschreibung

Die Erfindung betrifft ein Verfahren zur Herstellung eines optoelektronischen Bauelements und ist in Anspruch 1 definiert.

Die Herstellung von optoelektronischen Bauelementen, die Linsen aufweisen, wird bislang durch Verfahren realisiert, die hohe Kosten, einen großen Montageaufwand und mangelnde mechanische Festigkeit der Linse mit sich führen.

JP 2001 203395 A (SANYO ELECTRIC CO; 27. Juli 2001) offenbart ein Verfahren, bei dem eine Linse auf eine Leuchtdiode aufgebracht wird, wobei als Linsenmaterial ein Silikon- oder Epoxidharz verwendet wird. Auf eine erste, zunächst durch eine Temperatureinwirkung von 100 °C bis 150 °C vorgehärtete Linse wird ein weiteres Harz aufgebracht, um eine zweite Linse zu formen. Das erste Linsenmaterial wird durch eine 30-sekündige Temperatureinwirkung zunächst vor- bzw. angehärtet. Anschließend wird ein zweites Linsenmaterial auf die vor- bzw. angehärtete erste Linse aufgebracht und ebenso durch eine 30-sekündige Temperatureinwirkung zwischen 100 °C und 150 °C vor- bzw. angehärtet.

Aufgabe der Erfindung ist es, ein kostengünstiges und einfach durchzuführendes Verfahren anzugeben, mit dem eine Linse in einem optoelektronischen Bauelement aufgebracht werden kann. Diese Aufgabe wird durch ein Verfahren gemäß Anspruch 1 gelöst. Ein optoelektronisches Bauelement, das nach dem erfindungsgemäßen Verfahren hergestellt ist, wird auch beschrieben. Weitere Ausführungsformen des Verfahrens sind Gegenstand weiterer Ansprüche.
Gemäß einer Ausführungsform wird ein Verfahren zur Herstellung eines optoelektronischen Bauelements angegeben, das die Verfahrensschritte A) Bereitstellen einer strahlungsemittierenden Vorrichtung, B) Erwärmen der Vorrichtung und C) Aufbringen eines flüssigen Linsenmaterials im Strahlengang der Vorrichtung, wobei unter Vernetzung des Linsenmaterials eine an die Vorrichtung angeformte Linse gebildet wird, umfasst. Es wird also auf eine bereits fertig gestellte, strahlungsemittierende Vorrichtung ein Linsenmaterial aufgebracht, so dass sich eine Linse bilden kann. Dies stellt einen einfachen Herstellungsprozess dar, in dem das Linsenmaterial auf die vorgewärmte Vorrichtung aufdispensiert wird und sich zu einer Linse formt, wobei zusätzliche Verfahrensschritte wie das separate Aufbringen und mechanische Befestigen einer bereits fertigen Linse auf der strahlungsemittierenden Vorrichtung entfallen.
Der Verfahrensschritt A) kann die Verfahrensschritte A1) Anordnen eines Trägers in der Kavität eines Gehäuses, A2) Anordnen einer strahlungsemittierenden Halbleiterschichtenfolge auf einem Träger, und A3) Aufbringen eines Vergusses auf die Halbleiterschichtenfolge umfassen. Es wird in dem Verfahrensschritt A) also eine strahlungsemittierende Vorrichtung fertig gestellt und für die Verfahrensschritte B) und C) bereitgestellt.

Im Verfahrensschritt B) wird die strahlungsemittierende Vorrichtung auf einen Temperaturbereich von 80°C bis 180°C, beispielsweise auf eine Temperatur von 150°C, erwärmt Bei dieser Temperatur wird die strahlungsemittierende Vorrichtung nicht beschädigt, ist aber warm genug, um zu einer Vernetzung des Linsenmaterials im Verfahrensschritt C) zu führen.
Weiterhin kann im Verfahrensschritt C) das flüssige Linsenmaterial eine geringere Temperatur aufweisen als die strahlungsemittierende Vorrichtung. Beispielsweise kann das flüssige Linsenmaterial Raumtemperatur aufweisen. Dadurch vernetzt das flüssige Linsenmaterial nicht, so lange es nicht mit der strahlungsemittierenden Vorrichtung in Kontakt tritt. Erst, wenn das Linsenmaterial auf der strahlungsemittierenden Vorrichtung aufgebracht ist, vernetzt es unter dem Temperatureinfluss, der durch die strahlungsemittierende Vorrichtung gegeben ist.

Im Verfahrensschritt C) kann weiterhin das Linsenmaterial auf die strahlungsemittierende Vorrichtung aufgetropft werden und auf der strahlungsemittierenden Vorrichtung ein Tropfen gebildet werden. Der Tropfen wird durch die strahlungsemittierende Vorrichtung erwärmt, so dass das Linsenmaterial, das thermisch vernetzbar ist, aufgrund der Erwärmung der strahlungsemittierenden Vorrichtung thermisch vernetzt. Es wird also ohne einen weiteren Verfahrensschritt eine Linse, die an die strahlungsemittierende Vorrichtung angeformt ist, gebildet. Die genaue Form der Linse kann durch die Prozessparameter beeinflusst werden. Prozessparameter umfassen beispielsweise die Temperatur der strahlungsemittierenden Vorrichtung und des Linsenmaterials, sowie die Zusammensetzung des Linsenmaterials. Einen weiteren Einfluss auf die Form der Linse kann die Fließgeschwindigkeit des Linsenmaterials, mit der das Material auf die strahlungsemittierende Vorrichtung aufgebracht wird, haben.

Weiterhin kann der Tropfen durch chemische Reaktion des Linsenmaterials mit dem Material des Vergusses der strahlungsemittierenden Vorrichtung auf der strahlungsemittierenden Vorrichtung fixiert werden. Die chemische Reaktion kann ein Anlösen und Verschmelzen des Linsenmaterials und des Materials des Vergusses sowie die Ausbildung von chemischen Verbindungen zwischen den Materialien umfassen. Die aus dem Tropfen geformte Linse ist somit auf dem Verguss fixiert, ohne dass zusätzliche mechanische Halterungen wie beispielsweise Metallklammern benötigt werden. Somit wird ein weiterer Verfahrensschritt, das Befestigen einer Linse auf der strahlungsemittierenden Vorrichtung, eingespart. Dadurch, dass keine mechanische Verbindung vorhanden ist, wird das Ausdehnungsverhalten des Vergusses und der Linse nicht beeinflusst, so dass keine mechanischen Spannungen entstehen.

Das Verfahren kann weiterhin einen auf den Verfahrensschritt C) folgenden Verfahrensschritt C1) umfassen, in dem die Linse einem Plasma ausgesetzt wird, wodurch eine nicht benetzende Oberflächenschicht der Linse gebildet wird. Die Oberflächenschicht kann eine Glasschicht sein, die durch die Plasmabehandlung des Linsenmaterials entsteht. Eine solche Oberflächenschicht ist nicht benetzend, so dass keine Staubpartikel oder Bauteile leicht an der Linse anhaften können. Weitere Verfahren, um eine nicht benetzende Oberflächenschicht der Linse zu erhalten, können die Verwendung einer speziellen Mischung des Linsenmaterials oder eine zusätzliche Beschichtung der fertig geformten Linse umfassen.

Es wird weiterhin ein optoelektronisches Bauelement angegeben, das nach dem oben beschriebenen Verfahren hergestellt wird, und eine strahlungsemittierende Vorrichtung sowie eine an die Vorrichtung angeformte Linse umfasst. Ein solches optoelektronisches Bauelement weist eine hohe Strahlungsintensität auf, die durch die Linse, die im Strahlengang der strahlungsemittierenden Vorrichtung angeordnet ist, erzeugt wird.

Das Linsenmaterial kann ein Silikongel umfassen, das unter dem Temperatureinfluss der strahlungsemittierenden Vorrichtung zu einem Silikonharz vernetzt und somit thermisch vernetzbar sein kann. Das Silikongel kann weiterhin Härter, Katalysatoren oder weitere Zusätze umfassen, die vor dem Auftropfen des Silikongels auf die Vorrichtung mit dem Silikongel vermischt werden und die die Beschaffenheit des Harzes gemäß den gewünschten Eigenschaften der Linse beeinflussen. Beispielsweise führt eine Erhöhung des Anteils des Härters in dem Silikongel zu einem weniger klebrigen und weniger gelartigem Silikonharz Silikonharze können auch bei hoher Lichtintensität eingesetzt werden, ohne dass sie beschädigt werden. Weiterhin ist ein solches Linsenmaterial kostengünstig, was den Herstellungsprozess für das optoelektronisches Bauelement vergünstigt.

Das optoelektronische Bauelement kann eine strahlungsemittierende Vorrichtung aufweisen, die einen Träger und eine Halbleiterschichtenfolge auf dem Träger umfasst, die in der Kavität eines Gehäuses angeordnet sind. Weiterhin kann über der Halbleiterschichtenfolge in der Kavität des Gehäuses ein Verguss angeordnet sein. Der Verguss kann beispielsweise ein Silikonharz umfassen, das dem Silikonharz des Linsenmaterials entspricht oder von ihm unterschiedlich ist. Der Verguss kann weiterhin ein Epoxidharz umfassen. Die Halbleiterschichtenfolge kann einen LED-Chip umfassen.

Anhand der Figuren soll die Erfindung näher erläutert werden:
- Figur 1: zeigt einen schematischen Querschnitt eines optoelektronischen Bauelements.
- Figur 2: zeigt in den Figuren 2a und 2b Aufnahmen einer strahlungsemittierenden Vorrichtung mit Linse.
- Figur 3: zeigt die Abstrahlcharakteristik des optoelektronischen Bauelements.

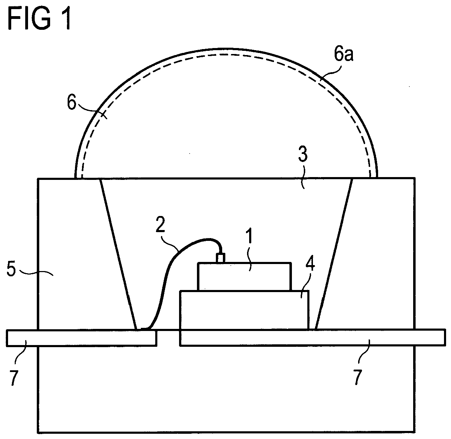

Figur 1 zeigt einen schematischen Querschnitt eines optoelektronischen Bauelements mit einer strahlungsemittierenden Vorrichtung und einer Linse. Die strahlungsemittierende Vorrichtung umfasst eine Halbleiterschichtenfolge 1, die direkt mit einer Leiterplatte 7 und über einen Anschluss 2 mit einer Leiterplatte 7 kontaktiert ist. Die Halbleiterschichtenfolge ist weiterhin auf dem Träger 4 angeordnet. Die Halbleiterschichtenfolge 1 und der Träger 4 befinden sich in der Kavität eines Gehäuses 5, in der außerdem der Verguss 3 angeordnet ist. Über dem Verguss 3 und dem Gehäuse ist die Linse 6 angeordnet, die eine Oberflächenschicht 6a umfasst. Der Verguss 3 und die Linse 6a sind aus Materialien, die miteinander beim Aufbringen des Linsenmaterials auf die vorgewärmte strahlungsemittierende Vorrichtung chemisch reagieren können. Beispielsweise kann es sich bei dem Material des Vergusses sowie dem Material der Linse um gleiche oder voneinander verschiedene Silikonharze handeln. Die Oberflächenschicht der Linse kann eine Glasschicht sein, die durch eine Plasmabehandlung der Linse entsteht. Sie kann weiterhin eine zusätzlich aufgebrachte Beschichtung umfassen, die Materialien aufweist, die nicht klebrige und nicht benetzende Eigenschaften aufweisen. Die Linse 6 ist also durch eine chemische Verbindung des Linsenmaterials mit dem Material des Vergusses 3 auf der strahlungsemittierenden Vorrichtung fixiert. Sie ist derart geformt, dass sie zu einer hohen Strahlungsintensität des emittierten Lichts der strahlungsemittierenden Vorrichtung führt. Durch die Oberflächenschicht 6a zieht die Linse 6 keinen Schmutz an und ist nicht klebrig für andere Bauteile.

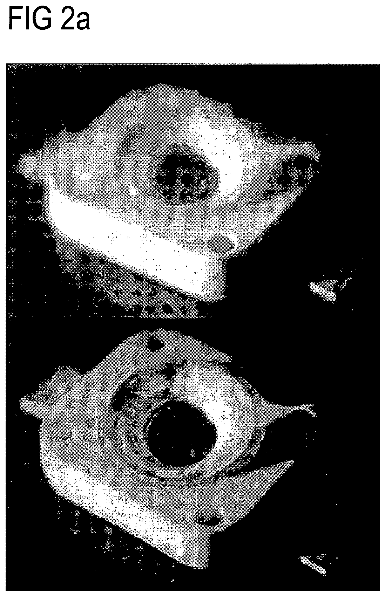

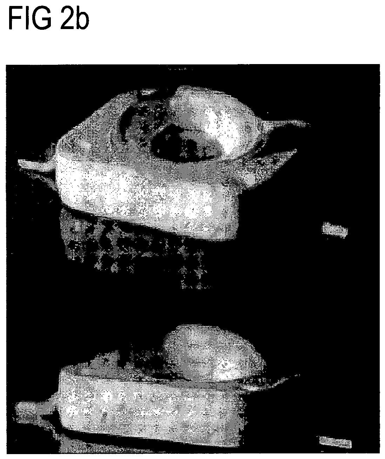

Figur 2 zeigt in Figur 2a die Draufsicht auf eine strahlungsemittierende Vorrichtung mit Linse, und in Figur 2b die Seitenansicht dieser strahlungsemittierenden Vorrichtung mit Linse. Bei der strahlungsemittierenden Vorrichtung handelt es sich um einen LED-Chip, auf dem eine Linse aus Silikonharz aufgebracht ist. Die Linse wurde im oben beschriebenen Verfahren in Form eines flüssigen Linsenmaterials, beispielsweise ein Silikongel, auf den LED-Chip aufgetropft, wobei der LED-Chip erwärmt war. Dadurch hat sich das Linsenmaterial vernetzt und hat sich in Form einer Linse auf dem LED-Chip verfestigt. Somit wurde in einem einfachen kostengünstigen Prozess die Linse auf den LED-Chip aufgebracht. Zusätzliche mechanische Fixierungen sind nicht notwendig. Der LED-Chip weist außerdem noch Seitenarme auf, die es ermöglichen, den Chip auf oder an andere Bauteile zu löten.

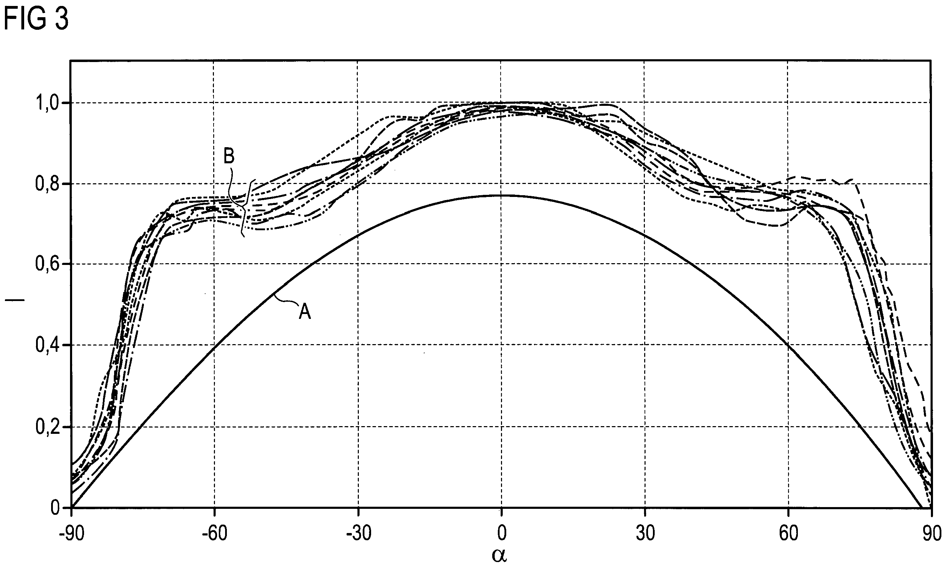

Figur 3 zeigt die Abstrahlcharakteristik des abgestrahlten Lichts eines optoelektronischen Bauelements, das eine strahlungsemittierende Vorrichtung mit Linse umfasst. Gezeigt ist die Intensität I in willkürlichen Einheiten gegen den Abstrahlwinkel α in °. Die Linie A zeigt eine ideale Cosinuskurve, die die Abstrahlcharakteristik einer strahlungsemittierenden Vorrichtung ohne Linse darstellt. Die Messdaten B zeigen Intensitätsmessungen einer strahlungsemittierenden Vorrichtung, einem LED-Chip, auf dem eine Linse nach dem oben beschriebenen Verfahren aufgebracht ist. Man sieht, dass die Strahlungsintensität der strahlungsemittierenden Vorrichtung durch die Linse erhöht wird, da die Effizienz der emittierten Strahlung, die die Fläche unter den Kurven darstellt, um etwa 20 Prozent im Vergleich zu der Cosinuskurve gestiegen ist.

Die Abstrahlcharakteristik wird durch das Aufbringen der Linse gegenüber einer strahlungsemittierenden Vorrichtung ohne Linse verändert, was durch die unterschiedlichen Peaks der Messdaten zu sehen ist. Bei vielen Anwendungen von optoelektronischen Bauelementen spielt das jedoch keine Rolle.

## Patentansprüche

1. Verfahren zur Herstellung eines optoelektronischen Bauelements mit den Verfahrensschritten
A) Bereitstellen einer strahlungsemittierenden Vorrichtung,
B) Erwärmen der Vorrichtung auf einen Temperaturbereich von 80°C bis 180°C,
C) Aufbringen eines flüssigen Linsenmaterials auf die vorgewärmte Vorrichtung bei dieser Temperatur im Strahlengang der Vorrichtung, wobei unter Vernetzung des Linsenmaterials eine an die Vorrichtung angeformte Linse (6) gebildet wird.

2. Verfahren nach dem vorhergehenden Anspruch, wobei der Verfahrensschritt A) die Verfahrensschritte
A1) Anordnen eines Trägers (4) in der Kavität eines Gehäuses (5),
A2) Anordnen einer strahlungsemittierenden Halbleiterschichtenfolge (1) auf einem Träger (4), und
A3) Aufbringen eines Vergusses (3) auf die Halbleiterschichtenfolge (1) umfasst.

3. Verfahren nach einem der vorhergehenden Ansprüche, wobei im Verfahrensschritt C) das flüssige Linsenmaterial eine geringere Temperatur aufweist als die strahlungsemittierende Vorrichtung.

4. Verfahren nach dem vorhergehenden Anspruch, wobei im Verfahrensschritt C) das Linsenmaterial auf die strahlungsemittierende Vorrichtung aufgetropft wird und auf der strahlungsemittierenden Vorrichtung ein Tropfen gebildet wird.

5. Verfahren nach dem vorhergehenden Anspruch, wobei der Tropfen durch chemische Reaktion des Linsenmaterials mit dem Material des Vergusses (3) auf der strahlungsemittierenden Vorrichtung fixiert wird.

6. Verfahren nach einem der vorhergehenden Ansprüche, wobei das flüssige Linsenmaterial thermisch vernetzbar ist und aufgrund der Erwärmung der strahlungsemittierenden Vorrichtung thermisch vernetzt wird.

7. Verfahren nach einem der Ansprüche 1 bis 6, wobei in einem auf den Verfahrensschritt C) folgenden Verfahrensschritt C1) die Linse (6) einem Plasma ausgesetzt wird, wodurch eine nicht-benetzende Oberflächenschicht (6a) der Linse (6) gebildet wird.

## Claims

1. A method for producing an optoelectronic component comprising the steps:
A) Providing a radiation-emitting device,
B) Heating the device to a temperature range of 80°C to 180°C,
C) Applying a liquid lens material on the preheated device at this temperature in a beam path of the device, wherein, with crosslinking of the lens material, a lens (6) shaped onto the device is formed.

2. The method according to the preceding claim, wherein step A) comprises the steps:
A1) Arranging a carrier (4) in a cavity of a housing (5),
A2) Arranging a radiation-emitting semiconductor layer sequence (1) on a carrier (4), and
A3) Applying a potting material (3) to the semiconductor layer sequence (1).

3. The method according to any of the preceding claims, wherein in step C), the liquid lens material is at a lower temperature than the radiation-emitting device.

4. The method according to the preceding claim, wherein, in step C), the lens material is applied dropwise to the radiation-emitting device and a drop is formed
on the radiation-emitting device.

5. The method according to the preceding claim, wherein the drop is fixed by chemical reaction of the lens material with potting material (3) on the radiation-emitting device.

6. The method of any of the preceding claims, wherein the liquid lens material is thermally crosslinkable and is thermally crosslinked by heating of the radiation-emitting device.

7. The method according to any of claims 1 to 6, further comprising a step C1) following step C), wherein the lens (6) is subjected to a plasma, whereby a non-wetting surface layer (6a) of the lens (6) is formed.

## Revendications

1. Procédé de fabrication d'un composant optoélectronique comprenant les étapes de procédé
A) fourniture d'un dispositif émetteur d'un rayonnement,
B) réchauffage du dispositif à une plage de température de 80°C à 180°C,
C) application d'un matériau liquide de lentille sur le dispositif préchauffé à cette température dans la trajectoire de rayonnement dudit dispositif, une lentille (6) ménagée sur le dispositif étant formée par réticulation du matériau de lentille.

2. Procédé selon la revendication précédente, l'étape de procédé A) comprenant les étapes de procédés
A1) disposition d'un support (4) dans la cavité d'un boîtier (5),
A2) disposition d'une succession de couches de semi-conducteurs (1) sur un support (4), et
A3) application d'une matière d'enrobage (3) sur la succession de couches de semi-conducteurs (1).

3. Procédé selon l'une quelconque des revendications précédentes, à l'étape de procédé C) le matériau liquide de lentille présentant une température moins élevée que le dispositif émetteur d'un rayonnement.

4. Procédé selon la revendication précédente, à l'étape de procédé C) le matériau de lentille étant déposé goutte-à-goutte sur le dispositif émetteur d'un rayonnement et une goutte se formant sur le dispositif émetteur d'un rayonnement.

5. Procédé selon la revendication précédente, la goutte étant fixée sur le dispositif émetteur d'un rayonnement par réaction chimique entre le matériau de lentille et le matériau de la matière d'enrobage (3).

6. Procédé selon l'une quelconque des revendications précédentes, le matériau liquide de lentille pouvant être réticulé thermiquement et étant réticulé thermiquement à cause du réchauffement du dispositif émetteur d'un rayonnement.

7. Procédé selon l'une quelconque des revendications 1 à 6, à une étape C1) suivant l'étape de procédé C) la lentille étant soumise à un plasma, ce qui permet de former une couche de surface (6a) de la lentille (6) non réticulante.
